(19) Europäisches Patentamt / European Patent Office / Office européen des brevets

(11) **EP 2 838 199 B1**

(12) **FASCICULE DE BREVET EUROPEEN**

(45) Date de publication et mention
de la délivrance du brevet:
**22.05.2019 Bulletin 2019/21**

(21) Numéro de dépôt: **14180654.7**

(22) Date de dépôt: **12.08.2014**

(51) Int Cl.:
***H03K 19/00*** *(2006.01)*

(54) **Circuit logique à interrupteurs mécaniques à faible consommation**

Energiesparender logischer Schaltkreis mit mechanischen Schaltern

Logic circuit with low-consumption mechanical switches

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **14.08.2013 FR 1358016**

(43) Date de publication de la demande:
**18.02.2015 Bulletin 2015/08**

(73) Titulaire: **Commissariat à l'Énergie Atomique et aux Énergies Alternatives 75015 Paris (FR)**

(72) Inventeurs:
 • **Fanet, Hervé**
 **38420 REVEL (FR)**
 • **Belleville, Marc**
 **38120 SAINT-EGREVE (FR)**

(74) Mandataire: **Brevalex
95, rue d'Amsterdam
75378 Paris Cedex 8 (FR)**

(56) Documents cités:
 **EP-A1- 2 549 654     EP-A2- 0 626 758**

 • TAKAHASHI K ET AL: "AN ULTRA-LOW POWER EXPANDABLE 4-BIT ADDER/SUBTRACTER IC USING ADIABATIC DYNAMIC CMOS LOGIC CIRCUIT TECHNOLOGY", EXTENDED ABSTRACTS OF THE INTERNATIONAL CONFERENCE ON SOLIDSTATE DEVICES AND MATERIALS, JAPAN SOCIETY OF APPLIED PHYSICS. TOKYO, JA, 1 janvier 1999 (1999-01-01), page 266/267, XP000935082,
 • DE GROOT W A ET AL: "Review of Device and Reliability Physics of Dielectrics in Electrostatically Driven MEMS Devices", IEEE TRANSACTIONS ON DEVICE AND MATERIALS RELIABILITY, IEEE SERVICE CENTER, PISCATAWAY, NJ, US, vol. 9, no. 2, 1 juin 2009 (2009-06-01), pages 190-202, XP011347953, ISSN: 1530-4388, DOI: 10.1109/TDMR.2009.2020565
 • AKARVARDAR K ET AL: "Design Considerations for Complementary Nanoelectromechanical Logic Gates", ELECTRON DEVICES MEETING, 2007. IEDM 2007. IEEE INTERNATIONAL, IEEE, PISCATAWAY, NJ, USA, 10 décembre 2007 (2007-12-10), pages 299-302, XP031389677, ISBN: 978-1-4244-1507-6

**Description**

**DOMAINE TECHNIQUE ET ART ANTÉRIEUR**

La présente invention se rapporte à un circuit logique à faible consommation.

Les circuits logiques de l'état de la technique sont réalisés en technologie CMOS ("Complementary Metal-Oxide Semiconductor" en terminologie anglo-saxonne) qui associe une paire de transistors complémentaires, l'un de type N, l'autre de type P, sur un même support.

En particulier à cause du développement des systèmes électroniques autonomes, on cherche à contrôler la consommation des circuits intégrés afin de la réduire. Plusieurs solutions peuvent être mises en oeuvre, l'une consiste à réduire la tension d'alimentation des circuits, en effet la consommation dite dynamique est proportionnelle au carré de cette tension, l'autre solution consiste à favoriser la mise en oeuvre de plusieurs circuits fonctionnant à des fréquences relativement lentes par rapport à un système fonctionnant à fréquence élevée. Cependant ces solutions présentent des limites liées à la réduction de taille de transistors.

Il existe une autre solution appelée logique adiabatique qui consiste à contrôler de manière optimale les charges et décharges des capacités d'un circuit intégré, ces capacités étant principalement celles des lignes d'interconnexion qui sont en général supérieures à celles des transistors. La logique adiabatique est décrite dans le document W C Athas, "Low power Digital systems based on adiabatic switching principles", IEEE transactions on VLSI systems VOL 2, N04 December 1994.

Un inverseur logique en technologie CMOS classique comporte un transistor p et un transistor n. Une fonction logique quelconque est réalisée par une combinaison de transistors en série ou en parallèle.

Dans la logique classique, à chaque changement d'état, la capacité CL des lignes d'interconnexion est chargée à la tension d'alimentation VDD puis déchargée à la masse. Une énergie est donc dissipée thermiquement et s'écrit :

$E = C_L \cdot V_{DD}^2$ On peut montrer de manière théorique que pour minimiser l'énergie dissipée par effet Joule dans la résistance en série avec une capacité, il faut garantir que les opérations de charge et de décharge s'effectuent à courant constant ce qui n'est pas le cas en logique classique. Dans ce cas, il est facile de montrer que l'énergie dissipée pendant le temps T pendant lequel on charge ou on décharge la capacité s'écrit :

$$E = \frac{RC_L}{T} \cdot C_L \cdot V_{DD}^2$$

La résistance R est la somme des résistances entre l'alimentation et l'entrée de la ligne d'interconnexion (résistance de l'interrupteur utilisé + résistances des lignes de connexion). Pour établir ce résultat, Il suffit de résoudre le système d'équations :

$$Q = iT$$
$$Q = C_L V_{DD}$$
$$E = Ri^2 T$$

Q est la charge stockée dans la capacité de la ligne d'interconnexion (en fait cette capacité plus la capacité d'entrée de l'étage suivant mais en général plus faible).

Le courant constant de charge et de décharge est i.

La tension à établir sur la ligne d'interconnexion est la tension d'alimentation (la charge étant supposée quasi-totale).

T est le temps pendant lequel on charge ou on décharge la ligne d'interconnexion.

En pratique, pour se rapprocher de cette condition idéale, les circuits proposés à ce jour sont basés sur une variation linéaire de la tension d'alimentation pendant les opérations de charge et de décharge des capacités ce qui revient au premier ordre à travailler à courant constant. Le cas de l'inverseur permet de préciser ce mode de fonctionnement.

En logique adiabatique, dans le cas de l'inverseur, la tension d'alimentation n'est plus constante comme dans la logique classique, mais est établie relativement lentement à chaque changement d'état. Les entrées (input) sont positionnées puis la tension d'alimentation $V_{alim}$ est progressivement amenée à la tension nominale VDD pendant un temps T, ce qui permet d'établir le niveau de sortie puis de transmettre ce niveau aux portes suivantes. L'opération contraire est ensuite effectuée pour remettre le système à zéro et traiter un autre événement logique. De la même manière, la tension d'alimentation $V_{alim}$ est alors relativement lentement baissée de $V_{DD}$ à zéro.

Dans la mesure où la capacité CL est chargée et déchargée lentement par rapport à la constante de temps typique du circuit RCL, R étant la résistance globale associée au processus de charge et de décharge, qui inclut la résistance de sortie du ou des transistors réalisant les fonctions F ainsi que la résistance des connexions, la tension aux bornes de la capacité CL peut suivre la tension appliquée en entrée. La tension aux bornes de la résistance est donc quasi nulle et la consommation thermique peut donc être réduite de manière importante par rapport à la logique classique.

L'énergie dissipée lors de la charge peut alors s'écrire comme dans le cas idéal de la charge à courant constant :

$$E = \frac{RC_L}{T} \cdot C_L \cdot V_{DD}^2$$

Lors de la décharge une énergie équivalente est dissipée.

Par conséquent l'énergie dissipée en logique adiabatique peut être réduite de manière importante à condition que la période T soit très supérieure aux constantes de temps RCL.

En pratique, la forme en trapèze du signal d'alimentation est souvent remplacée par un signal sinusoïdal ou en partie sinusoïdal plus facile à générer et constituant une approximation convenable.

Cette logique n'a cependant donné lieu à aucune réalisation industrielle. En effet, le calcul exposé ci-dessus ignore une caractéristique des transistors réalisés dans une technologie à base de semi-conducteurs à savoir l'effet de seuil. Pour rendre le transistor (ou les transistors) conducteurs dans la phase de charge ou de décharge des capacités, il faut que la tension de commande appliquée à la grille dépasse une valeur appelée tension de seuil et notée VT dans la technologie CMOS. En général la tension de commande et la tension d'alimentation sont de même valeur pour simplifier l'architecture. Dans le cas de l'inverseur en logique classique, lorsque l'entrée est à l'état «0», le transistor PMOS devient conducteur quand la tension d'alimentation est supérieure à la tension de seuil du transistor. Dans ce cas, une différence de tension va apparaître aux bornes de la résistance R dans le processus de charge (ou de décharge) tant que le transistor n'est pas conducteur. Cette valeur varie de 0 à VT pendant le cycle. Un courant non négligeable apparaît alors aux bornes de la résistance et génère une dissipation thermique.

L'énergie dissipée dans le processus de charge peut s'écrire en première approximation :

$$E = \frac{RC_L}{T} \cdot C_L \cdot V_{DD}{}^2 + \frac{1}{2} C_L \cdot V_T{}^2$$

Pour réduire cet effet négatif il faudrait réduire la tension de seuil VT à une valeur proche de 0, mais dans la technologie CMOS cette solution est inapplicable car elle conduirait à une consommation statique non tolérable due au courant sous le seuil. La consommation statique est liée au courant de fuite des transistors (conduction résiduelle en dessous du seuil), elle varie exponentiellement avec la diminution de la tension de seuil et des rapports VT/VDD supérieurs à 0,2 voire 0,4 dans des technologies basse consommation sont nécessaires.

Par conséquent, la logique adiabatique théoriquement d'un grand intérêt est incapable de réduire largement la consommation des circuits réalisés dans une technologie d'interrupteurs à base de semi-conducteurs, présentant des effets de seuil.

Le document EP 2 549 654 A1 décrit un circuit logique comportant des interrupteurs microélectromécaniques ou nanoélectromécaniques.

## EXPOSÉ DE L'INVENTION

C'est par conséquent le but de la présente invention d'offrir un circuit logique à consommation d'énergie très faible.

Le but précédemment énoncé est atteint par un circuit logique adiabatique selon la revendication indépendante 1 présentant au moins une première et une deuxième entrées, une première et une deuxième sorties et une entrée d'alimentation et de synchronisation délivrant une tension d'alimentation adiabatique, ce circuit comportant :

- un premier dispositif logique comprenant au moins un interrupteur microélectromécanique ou MEMS ou nanoélectromécanique NEMS piloté au moins en partie par la première entrée et destiné à relier la première sortie et l'entrée d'alimentation et de synchronisation,
- un deuxième dispositif logique comprenant au moins un interrupteur MEMS/NEMS piloté au moins en partie par la deuxième entrée et destiné à relier la deuxième sortie et l'entrée d'alimentation et de synchronisation,
- un premier et un deuxième dispositif assurant une décharge au moins partielle de la première sortie vers l'entrée d'alimentation et de synchronisation et de la deuxième sortie vers l'entrée d'alimentation et de synchronisation.

De manière avantageuse, le premier et le deuxième dispositif de décharge comportent respectivement au moins un interrupteur.

De manière préférée, les interrupteurs des dispositifs de décharge ont à cycle d'hystérésis. L'interrupteur bistable est un cas particulier d'interrupteur à cycle d'hystérésis. Ces interrupteurs présentent avantageusement le comportement suivant : la variation de la résistance en fonction de la tension de commande suit l'évolution suivante: elle passe d'une valeur très élevée (Roff) à une valeur basse (Ron) quand la tension de commande est plus grande qu'une tension VPI mais ne revient à la valeur Roff que si la tension de commande est inférieure à une valeur VRL, cette valeur étant avantageusement largement plus faible que VPI. On montre alors que la dissipation non adiabatique variant avec le carré de VRL est d'autant plus faible que la valeur de VRL est faible et que la dissipation adiabatique proportionnelle à Ron est d'autant plus faible que la valeur de Ron est faible. De plus, pour réduire la consommation statique il est avantageux d'avoir une valeur Roff la plus élevée possible. Ron et Roff peuvent légèrement varier entre VRL et VPI. Une augmentation trop importante de Ron entraine cependant une augmentation de la dissipation. Ces propriétés peuvent être obtenues avec les interrupteurs électromécaniques mais elles ne peuvent pas être obtenues avec les transistors MOSFets à base de semi-conducteurs.

Les interrupteur sont par exemple des interrupteurs MEMS/NEM, ils peuvent être commandés de manière électrostatique, de manière piézoélectrique, de manière magnétique ou de manière thermique.

On entend par une tension d'alimentation adiabatique une tension d'alimentation établie relativement lentement, cette tension d'alimentation étant ensuite abaissée relativement lentement de sorte qu'elle charge et décharge à courant quasi constant une ligne d'interconnexion.

En d'autres termes, le circuit ou unité logique réalisant une fonction logique selon l'invention, comporte une fonction logique et sa fonction logique inverse fonctionnant en logique adiabatique. Chaque fonction logique comporte au moins une entrée et une sortie. L'unité logique comporte également au moins une entrée d'alimentation et de synchronisation pour appliquer la tension d'alimentation en logique adiabatique, la fonction logique et sa fonction logique inverse mettant en oeuvre des interrupteurs microélectromécaniques ou MEMS ou nanoélectromécaniques ou NEMS. L'unité logique comportant également des moyens aptes à maintenir la connexion entre la sortie et l'entrée d'alimentation et de synchronisation après que l'entrée a changé d'état assurant ainsi une décharge adiabatique au moins partielle de la sortie avec l'entrée d'alimentation et de synchronisation.

Dans des modes avantageux, la connexion entre la sortie et l'entrée d'alimentation et de synchronisation peut être maintenue jusqu'à la décharge complète de la sortie. On obtient alors une décharge entièrement adiabatique.

Dans un exemple de réalisation, on peut prévoir une connexion à la masse de la sortie pour éviter l'influence de charges électrostatiques susceptibles de perturber la sortie du circuit.

La présente invention a alors pour objet un circuit logique adiabatique selon la revendication 1 comportant au moins une première et une deuxième entrées, une première et une deuxième sorties et au moins une entrée d'alimentation et de synchronisation , ce circuit comportant :

- un premier dispositif logique comprenant au moins un premier interrupteur microélectromécanique et/ou nanoélectromécanique, dit premier interrupteur logique, au moins en partie piloté par la première entrée et relié à la première sortie et à l'entrée d'alimentation et de synchronisation,
- un deuxième dispositif logique dit complémentaire assurant une fonction logique complémentaire du premier dispositif logique comprenant au moins un deuxième interrupteur microélectromécanique et/ou nanoélectromécanique, dit deuxième interrupteur logique, au moins en partie piloté par la deuxième entrée et relié à la deuxième sortie et à l'entrée d'alimentation et de synchronisation,
- des premier et deuxième dispositifs de décharge reliés respectivement entre la première sortie et l'entrée d'alimentation et de synchronisation et entre la deuxième sortie et l'entrée d'alimentation et de synchronisation, lesdits premier et deuxième dispositifs de décharge assurant une décharge au moins partielle des première et deuxième sorties.

Selon l'invention l'entrée d'alimentation et de synchronisation est une horloge d'alimentation appelée en terminologie anglo-saxonne "power clock" qui permet à la fois de fournir une alimentation électrique au circuit logique tout en synchronisant les signaux logiques. Avantageusement cette alimentation permet également de récupérer une grande partie de l'énergie électrique fournie au circuit de sorte à former une horloge d'alimentation adiabatique.

Selon l'invention, les première et deuxième entrées peuvent permettre respectivement l'introduction dans le circuit logique de un ou plusieurs signaux logiques. Selon l'invention, le premier et le deuxième dispositif de décharge comportent respectivement au moins un interrupteur microélectromécanique et/ou nanoélectromécanique, dit interrupteur décharge.

Dans un mode de réalisation, la première sortie est reliée à la masse par l'intermédiaire d'un troisième dispositif logique complémentaire du premier dispositif logique et piloté par la deuxième entrée et la deuxième sortie est reliée à la masse par l'intermédiaire d'un quatrième dispositif logique complémentaire du deuxième dispositif logique et piloté par la première entrée.

Le troisième dispositif logique peut comporter un premier interrupteur microélectromécanique et/ou nanoélectromécanique de connexion à la masse, ledit premier interrupteur de connexion à la masse étant commandé de sorte à être dans un état inverse de celui du premier interrupteur logique, et le quatrième dispositif logique comporte un deuxième interrupteur microélectromécanique et/ou nanoélectromécanique de connexion à la masse, ledit deuxième interrupteur de connexion à la masse étant commandé de sorte à être dans un état inverse de celui du deuxième interrupteur logique.

Selon une caractéristique additionnelle, tout ou partie des interrupteurs logiques sont des interrupteurs bistables

Les interrupteurs bistables par rapport à des interrupteurs classiques, comportent une électrode de commande pour ouvrir l'interrupteur et une électrode de commande pour fermer l'interrupteur ; ces interrupteurs conservent leur état (ouvert ou fermé) lorsque les commandes sont inactives. Cet effet de bistabilité des interrupteurs logiques est de façon connue obtenu par conception desdits interrupteurs.

Les premier et deuxième dispositifs de décharge peuvent être commandés respectivement par la première sortie et la deuxième sortie.

Selon un autre exemple de réalisation, le circuit logique comporte aux moins une première entrée de synchronisation et préférentiellement une deuxième entrée de synchronisation, et chacun des premier et deuxième dispositifs de décharge comportant préférentiellement au moins trois interrupteurs microélectromécaniques et/ou nanoélectromécaniques, dans lequel un des trois interrupteurs du premier dispositif de décharge est destiné à réaliser la connexion entre la première sortie et l'entrée d'alimentation et de synchronisation, un autre parmi les trois interrupteurs du premier dispositif de décharge est commandé par la première entrée de synchronisation de sorte à maintenir la connexion entre la première sortie et l'entrée d'alimentation et de synchronisation jusqu'à décharge complète de la première sortie, en conservant l'interrupteur conducteur, et préférentiellement la deuxième entrée de synchronisation assure la connexion entre la première sortie et l'entrée d'alimentation et de synchronisation en fermant un autre des trois interrupteurs du premier dispositif de décharge dans une phase inactive du circuit logique, et dans lequel un des trois interrupteurs du deuxième dispositif de décharge est destiné à réaliser la connexion entre la deuxième sortie et l'entrée d'alimentation et de synchronisation, un autre parmi les trois interrupteurs du deuxième dispositif de décharge est commandé par la première entrée de synchronisation de sorte à maintenir la connexion entre la deuxième sortie et l'entrée d'alimentation et de synchronisation jusqu'à décharge complète de la deuxième sortie, en conservant l'interrupteur conducteur, et la deuxième entrée de synchronisation assure la connexion entre la deuxième sortie et l'entrée d'alimentation et de synchronisation en fermant un autre des trois interrupteurs du deuxième de décharge logique dans une phase inactive du circuit logique.

Dans un autre exemple de réalisation, le premier interrupteur logique du premier dispositif logique forme une partie du premier dispositif de décharge, ledit premier interrupteur logique étant commandé en fermeture et en ouverture, ledit premier interrupteur logique étant commandé de sorte à assurer la décharge complète de la première sortie, et dans lequel le deuxième interrupteur logique du deuxième dispositif logique forme une partie du deuxième dispositif de décharge, ledit deuxième interrupteur logique étant commandé en fermeture et en ouverture, ledit deuxième interrupteur logique étant commandé de sorte à assurer la décharge complète de la deuxième sortie.

Dans un autre exemple de réalisation, le circuit logique peut également comporter une entrée de synchronisation commandant deux interrupteurs supplémentaires des premier et deuxième dispositifs de décharge de sorte que ladite entrée de synchronisation maintient l'un ou l'autre des interrupteurs supplémentaires fermé assurant la connexion entre la première sortie ou la deuxième sortie respectivement et l'entrée d'alimentation et de synchronisation, dans une phase inactive du circuit logique.

Les premier, deuxième interrupteurs logiques, les premier et deuxième interrupteurs de décharge et les premier et deuxième interrupteurs de mise à la masse peuvent être commandés par des forces électrostatiques, des forces magnétiques ou des forces piézoélectriques.

La présente invention a également pour objet un circuit intégré comportant au moins un circuit logique selon la présente invention.

Le circuit intégré peut comporter au moins un premier et un deuxième circuits logiques selon l'invention, la première sortie du premier dispositif logique du premier circuit appliquant un signal d'entrée à la première entrée du premier dispositif logique du deuxième circuit et la deuxième sortie du deuxième dispositif logique du premier circuit appliquant un signal d'entrée à la deuxième entrée du deuxième dispositif logique du deuxième circuit.

## BRÈVE DESCRIPTION DES DESSINS

La présente invention sera mieux comprise à l'aide de la description qui va suivre et des dessins en annexe sur lesquels:

- la figure 1 est une représentation d'un schéma de principe d'un circuit logique selon la présente invention,
- la figure 2A est une représentation schématique d'un exemple de réalisation d'un circuit logique selon un premier mode de réalisation,
- la figure 2B représente les chronogrammes des signaux aux différentes entrées et sorties du circuit logique de la figure 2A,
- la figure 3 est une représentation schématique d'un autre exemple d'un circuit logique selon un premier mode de réalisation,
- la figure 4 est une représentation schématique d'un autre exemple d'un circuit logique selon un premier mode de réalisation,
- la figure 5A est une représentation schématique d'un exemple de réalisation d'un circuit logique selon un deuxième mode de réalisation,
- la figure 5B représente les chronogrammes des signaux aux différentes entrées et sorties du circuit logique de la figure 5A,
- la figure 6A est une représentation schématique d'un exemple de réalisation d'un circuit logique selon un troisième mode de réalisation,
- la figure 6B représente les chronogrammes des signaux aux différentes entrées et sorties du circuit logique de la figure 6A,
- la figure 7 est une représentation schématique d'un exemple de réalisation d'un interrupteur pouvant être mis en oeuvre dans un circuit logique selon l'invention,
- la figure 8 est une représentation graphique de la variation de la tension d'alimentation en fonction du temps en logique adiabatique.

**EXPOSÉ DÉTAILLÉ DE MODES DE RÉALISATION PARTICULIERS**

La présente invention porte sur des circuits logiques en logique dynamique du type "dual rail", mettant en oeuvre une fonction logique et la fonction inverse.

La fonction logique est désignée F et la fonction inverse est désignée Fb. Les entrées et sorties se rapportant à la fonction inverse comportent l'indice b pour les distinguer des entrées et sorties de la fonction logique F.

Les circuits logiques selon l'invention comportent des interrupteurs mécaniques, plus particulièrement des nanointerrupteurs ou microinterrupteurs réalisés par technologie NEMS (Nanoelectromechanical Systems) ou MEMS (Microelectromechanical Systems). Au moins la fermeture de ces interrupteurs peut être commandée par des moyens électrostatiques, par application d'un champ magnétique, par effet piézoélectrique, par effet thermique ou par des moyens magnétiques. A des fins de simplicité, les " nano et microinterrupteurs "seront désignés uniquement par "interrupteurs mécaniques". Des exemples de tels interrupteurs mécaniques seront décrits pas la suite.

Dans les modes de réalisation qui vont être décrit les interrupteurs mécaniques sont à actionnement électrostatique.

De façon générale, pour l'ensemble des interrupteurs du circuit de l'invention, les tensions de commande sont référencées avantageusement par rapport à un potentiel fixe tel que la masse.

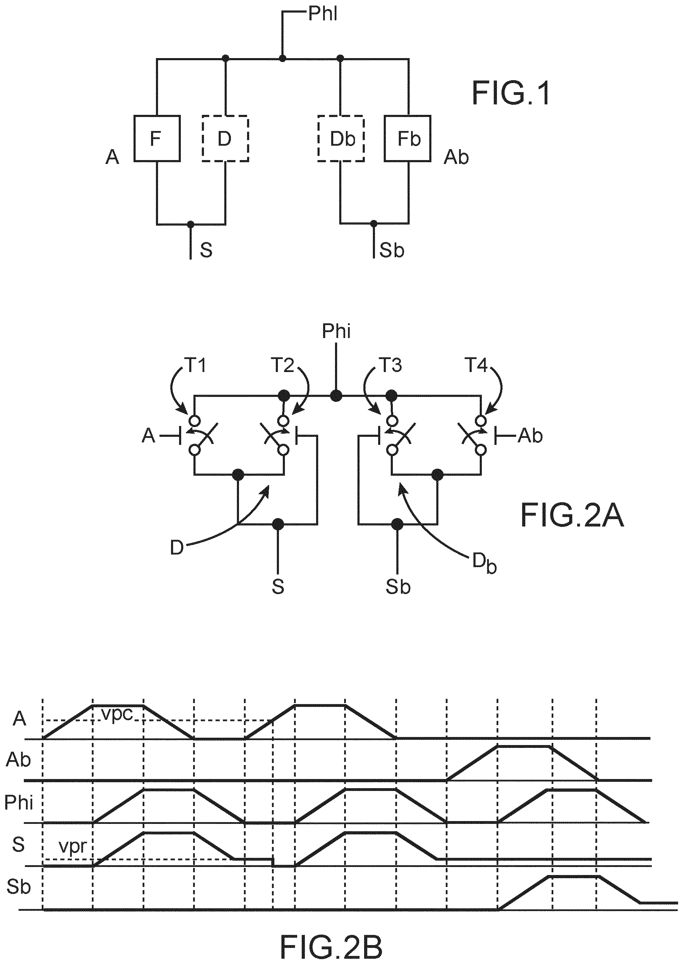

Sur la figure 1, on peut voir un schéma de principe d'un circuit logique selon l'invention.

Le circuit logique comporte la fonction F de type logique pilotée par une ou plusieurs entrée désignée A, la fonction inverse Fb pilotée par une ou plusieurs entrées complémentaires Ab, une ou plusieurs sortie S et une ou plusieurs sorties complémentaires Sb. Les fonctions F et Fb comportent au moins un interrupteur mécanique.

Le circuit logique présente une première entrée d'alimentation et de synchronisation ou horloge, désignée Phi, reliée à une source de tension d'alimentation adiabatique.

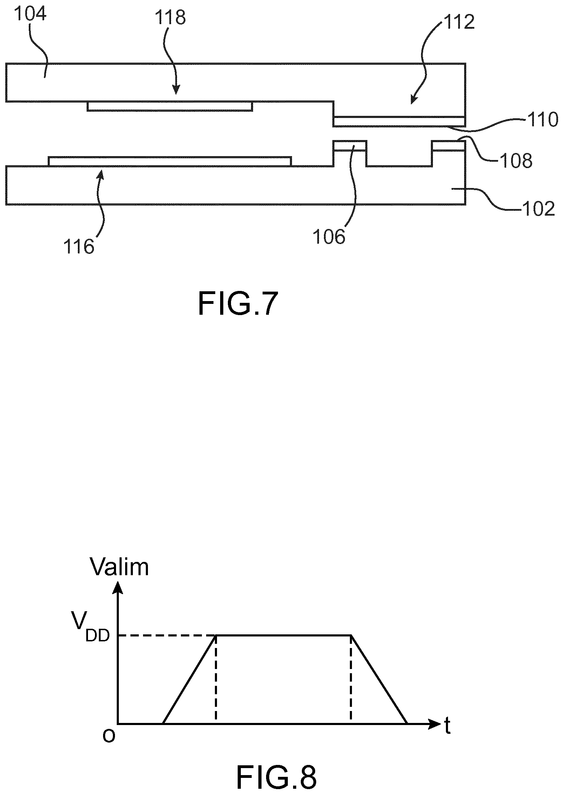

Par exemple, la source d'alimentation en tension est telle que la tension d'alimentation n'est pas constante et varie selon un profil trapézoïdal. La variation de la tension $V_{alim}$ est représentée schématiquement sur la figure 8. Dans une première phase I, la tension d'alimentation croît progressivement de 0 jusqu'à atteindre la tension nominale $V_{DD}$, pendant un temps T, ce qui permet d'établir le niveau de sortie puis de transmettre ce niveau aux portes suivantes. Dans une deuxième phase II, la tension d'alimentation $V_{alim}$ est maintenue pendant un certain temps à la tension nominale $V_{DD}$ et ensuite, lors d'une troisième phase III, la tension d'alimentation $V_{alim}$ décroît pendant le temps T pour remettre le système à zéro avant de traiter un autre événement logique. Le temps d'augmentation de la tension et le temps de diminution de la tension sont de préférence sensiblement égaux. En outre, le temps pendant lequel la tension est constante est sensiblement constant. En pratique, le profil trapézoïdal est approximé par une demi-sinusoïde.

Dans la logique adiabatique appelée également " logique à récupération d'énergie " (energy recovery logic en anglais), l'énergie stockée dans la capacité de l'interconnexion n'est pas déchargée à la masse comme dans la logique CMOS, ce qui introduit nécessairement une dissipation, mais vers l'alimentation qui a servi à la charger. Une grande partie de l'énergie est donc récupérée par l'alimentation. La logique adiabatique est également appelée logique à récupération d'énergie (energy recovery logic en anglais).

Dans la logique adiabatique, la tension d'alimentation varie dans le temps selon une loi en trapèze. En pratique il est assez difficile de réaliser une variation de ce type et une demi-sinusoïde constitue une approximation satisfaisante de la loi trapézoïdale. Pour générer une telle tension, on peut utiliser un circuit oscillant. Celui-ci peut comporter inductance est en série avec le circuit logique, le circuit oscillant étant excité à la fréquence choisie. Un circuit à base d'une batterie de condensateurs peut également être utilisé pour générer de manière approximative une tension trapézoïdale. Les condensateurs sont déchargés séquentiellement puis rechargés séquentiellement quand la ligne est remise à zéro et quand l'énergie est récupérée.

La première entrée d'alimentation et de synchronisation Phi est connectée à la fois à la fonction logique F et à la fonction inverse Fb.

Les signaux d'entrée sont également adiabatiques afin de pouvoir connecter en cascade plusieurs circuits logiques.

En outre, le circuit logique comporte des premiers moyens de décharge D permettant à la sortie S de se décharger vers la première entrée d'alimentation et de synchronisation Phi, et des deuxième moyens de décharge Db permettant à la sortie complémentaire Sb de se décharger vers la première entrée d'alimentation et de synchronisation Phi

Les moyens D et DB assurent la connexion entre la sortie S et Sb respectivement et la première entrée d'alimentation et de synchronisation Phi lorsque le signal en sortie vaut 1 et maintiennent cette connexion lorsque l'entrée A ou Ab est repassée à 0 et au plus tard jusqu'à ce que l'entrée A ou Ab débute la remontée à 1.

Ces moyens D et Db permettent alors à la sortie S et Sb respectivement de se décharger au moins en partie de manière adiabatique vers la première entrée d'alimentation et de synchronisation Phi. Cette décharge au moins en partie adiabatique permet de réduire la consommation électrique du circuit logique par rapport aux circuits logiques à transistor.

En outre, ces moyens D et Db permettent de maintenir les sorties à l'état 0 pendant la phase inactive, i.e. lorsqu'aucun signal d'entrée n'est appliqué à l'entrée A.

Nous allons maintenant décrire des modes de réalisation pratiques de circuits logiques selon la présente invention.

Sur la figure 2A, on peut voir un premier mode de réalisation d'un circuit logique formant un inverseur.

Dans ce premier mode de réalisation, la fonction logique F est réalisée par un interrupteur mécanique T1 et la fonction complémentaire Fb est réalisée par un interrupteur mécanique T4.

Les moyens de décharge D sont formés également par un interrupteur mécanique T2 et les moyens Db sont formés par un interrupteur mécanique T3.

Les interrupteurs mécaniques présentent un état fermé conducteur lorsqu'une tension supérieure au seuil de fermeture leur est appliquée, désignée VPC. L'état fermé conducteur représente l'état 1. Les interrupteurs mécaniques présentent un état ouvert lorsqu'une tension inférieure ou égale à un seuil de fermeture leur est appliquée, cette tension est désignée VPR. L'état ouvert non conducteur représente l'état 0. Les tensions VPC et VPR sont en général différentes.

Dans la présente demande, les expressions "interrupteur fermé" et "interrupteur conducteur" "interrupteur passant" sont considérées comme synonymes. Dans la présente demande, et les expressions "interrupteur ouvert" et "interrupteur non conducteur" ou "interrupteur bloqué" sont considérées comme synonymes.

Sur la figure 7, on peut voir représenté un exemple d'interrupteur commandé en fermeture à actionnement électrostatique.

L'interrupteur comporte une partie fixe 102 et une partie mobile 104.

La partie fixe 102 comporte une première piste conductrice 106 et une deuxième piste conductrice 108 qui sont destinées à être mise en contact à la fermeture de l'interrupteur. La partie mobile 104 comporte une piste conductrice 110 comprenant un élément en saillie 112, cet éléments en saillie 112 étant destiné à venir en contact avec les pistes conductrices 106 et 108 lorsque la partie mobile 104 est rapprochée de la partie fixe 102 et à assurer la conduction entre les deux pistes conductrices 106, 108.

L'interrupteur comporte des moyens de commande électrostatique en fermeture comportant une électrode 116 sur la partie fixe 102 et une électrode 118 sur la partie mobile, les électrodes 116 et 118 étant en regard. Lorsqu'une tension est appliquée entre les deux électrodes 116, 118 une attraction électrostatique apparaît entre les électrodes provoquant un rapprochement de la partie mobile 104 de la partie fixe 102; lorsque cette tension est suffisante, l'élément 112 entre en contact avec les pistes conductrices 106, 108 r et provoque la fermeture de l'interrupteur. Lorsque la tension de commande est insuffisante, la partie mobile reprend sa position initiale interrompant la conduction entre les pistes 106, 108.

Dans l'exemple représenté, la partie mobile 104 est formée par une poutre. En variante, l'élément suspendu peut être formé par une membrane.

Le fonctionnement de ce circuit logique va maintenant être décrit. Sur la figure 2B, sont représentées les variations d'état des entrées A, Ab, des sorties S, Sb et de l'horloge Phi en fonction du temps.

Tout d'abord, un signal d'entrée est par exemple appliqué à l'entrée A de sorte à la positionner à « 1 », l'entrée Ab est donc « 0 ».Le signal d"entrée est visible sur la figure 2B et varie de manière adiabatique.

Lorsque la tension en A atteint VPC, l'interrupteur mécanique T1 se ferme et devient conducteurs. Les autres interrupteurs T2, T3 et T4 sont ouverts car en début de cycle toutes les tensions sont à zéro.

La première entrée d'alimentation et de synchronisation Phi applique ensuite une tension d'alimentation qui augmente de 0 à $V_{DD}$. Du fait de la fermeture de T1, la sortie S connaît la même variation de tension comme cela est visible sur la figure 2B. La sortie Sb reste, quant à elle, à 0V.

La tension VPC est inférieure à la tension Vdd. La tension à la sortie S en augmentant jusqu'à Vdd, atteint et dépasse la valeur VPC, provoquant la fermeture de l'interrupteur mécanique T2 qui devient conducteur.

Le signal d'entrée appliqué à l'entrée A, variant adiabatiquement, la tension appliquée à l'entrée A et donc à l'interrupteur mécanique T1 diminue et devient inférieur à VPR, T1 alors s'ouvre et n'est plus conducteur. La sortie S reste cependant connectée à la première entrée d'alimentation et de synchronisation Phi par l'interrupteur mécanique T2. Or la tension à la première entrée d'alimentation et de synchronisation Phi diminue de manière adiabatique, la tension à la sortie S diminue alors également de manière adiabatique. Lorsque la tension à la sortie atteint VPR, l'interrupteur mécanique T2 s'ouvre, isolant alors la sortie de l'horloge Phi. La sortie S reste à alors à la tension VPR.

Comme cela a été expliqué ci-dessus, la ligne d'interconnexion à la sortie forme une capacité, la tension VPR s'applique donc aux bornes de la capacité d'interconnexion de la sortie. Cette tension reste à cette valeur dans le cycle suivant si l'entrée A est dans l'état « 0 » et se décharge vers la première entrée d'alimentation et de synchronisation Phi si dans le cycle qui suit l'entrée A est « 1 » , puisque la sortie S sera à nouveau connectée à la première entrée d'alimentation et de synchronisation par l'interrupteur mécanique T1. Dans l'exemple représenté, dans le cycle suivant l'entrée A passe à 1 provoquant la décharge de la sortie S.

La décharge de la tension VPR est non adiabatique et est égale à $\frac{1}{2} CV_{PR}^{2}$. D'une part l'énergie déchargée de manière non adiabatique par le circuit logique selon l'invention est sensiblement plus faible par rapport aux circuits logiques de l'état de la technique, car il ne s'agit que d'une partie de l'énergie qui est perdue par les circuits logiques de l'état de la technique. D'autre part, cette énergie peut être réduite en choisissant le type d'interrupteur mécanique mis en oeuvre, en particulier en optimisant les forces d'adhésion. En effet, contrairement aux transistors, une faible valeur de la tension VPR ne provoque pas une augmentation de la valeur du courant de fuite de l'interrupteur mécanique, puisque celui-ci ne présente pas de courant de fuite. Les forces d'adhésion peuvent être modifiées et ajustées en jouant sur la taille des électrodes de contact, la rugosité des électrodes de contact et la nature des matériaux utilisés. La valeur de la tension appliquée sur la grille modifie également la force appliquée et donc les forces d'adhésion.

On constate que le signal de sortie a la même durée que le signal d'entrée ce qui permet de connecter en cascade les portes logiques

Ce circuit logique est de structure simple, met en oeuvre des interrupteurs mécaniques simples et il n'utilise qu'une première entrée d'alimentation et de synchronisation, i.e. un seul signal de commande pour tous les interrupteurs mécaniques. Par ailleurs, les tensions aux entrées, sorties et à la première entrée d'alimentation et de synchronisation ont le même profil ce qui simplifie l'alimentation.

Dans le fonctionnement décrit ci-dessus, c'est l'entrée de la fonction logique qui passe à l'état 1, mais on peut prévoir que ce soit l'entrée Ab complémentaire qui passe à 1 et l'entrée 1 qui reste à 0, le fonctionnement est similaire à celui décrit ci-dessus en commutant les interrupteurs mécaniques T3 et T4.

La figure 2B montre le cas où c'est l'entrée complémentaire Ab qui passe à 1 lors du troisième cycle. Dans ce cas la sortie S reste à O et c'est la sortie complémentaire Sb qui varie de manière similaire à la sortie S dans les deux premiers cycles. A la fin du troisième cycle l'interrupteur T3 se ferme, isolant la sortie Sb. On constate que la sortie S reste chargée pendant le troisième cycle puisque l'entrée est restée à 0. Dans le quatrième cycle (non représenté), si l'entrée A passe à 1 ce sera la sortie S qui se décharge et si c'est l'entrée Ab c'est la sortie Sb.

Les valeurs VPR et VPC sont de préférence égales pour tous les interrupteurs ce qui permet une fabrication collective. En variante, il pourrait être prévu d'avoir des familles d'interrupteurs de mêmes caractéristiques.

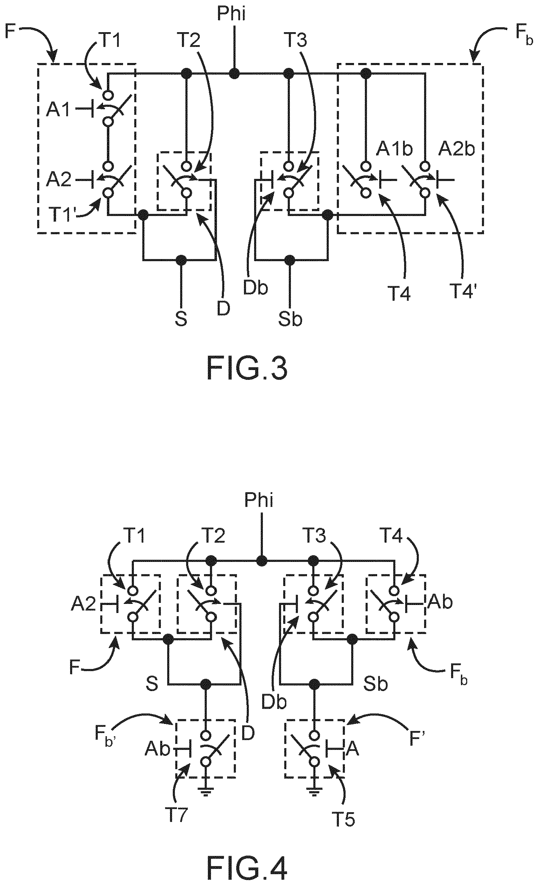

Sur la figure 3, on peut voir un autre exemple de circuit logique selon le premier mode de réalisation. Dan cet exemple, la fonction logique est une fonction ET a deux entrées A1 et A2. Elle est réalisée par deux interrupteurs T1 et T1' et la fonction complémentaire a également deux entrées A1b et A2b et est réalisée par deux interrupteurs T4 et T4'. Chaque entrée commande un interrupteur mécanique. Comme pour l'exemple de la figure 2A, les moyens D et Db sont formés chacun par un interrupteur mécanique.

Le fonctionnement de ce circuit logique est similaire à celui de la figure 2B, il diffère en ce que la connexion initiale entre la première entrée d'alimentation et de synchronisation Phi et la sortie S est commandée par la commutation de deux interrupteurs au lieu d'un.

Des fonctions logiques différentes et plus complexes peuvent être réalisées selon le même principe (ou, ou exclusif, nand, nor, porte de Toffoli, porte de Fredkin, porte de Feynman...).

Sur la figure 4, on peut voir un autre exemple de circuit logique inverseur comportant des retours à la masse.

Le circuit logique comporte une porte logique Fb' complémentaire de la fonction logique F reliant la sortie S à la masse, cette porte logique Fb' étant pilotée par l'entrée Ab. Le circuit logique comporte également une porte logique F' complémentaire de la porte logique complémentaire Fb reliant la sortie Sb à la masse, cette porte logique F' étant pilotée par l'entrée A.

La porte logique complémentaire Fb' comporte un interrupteur T7 positionné entre la sortie complémentaire S et la masse et la porte logique F' comporte un interrupteur T7 positionné entre la sortie complémentaire Sb et la masse. Ainsi quand l'interrupteur T1 commandé par l'entrée A, est fermé, l'interrupteur T7 commandé par l'entrée complémentaire Ab, est ouvert, et inversement.

Le fonctionnement de ce circuit logique est similaire à celui de la figure 2A, il diffère de celui-ci lorsque la tension en S atteint la valeur VPR et que l'interrupteur T2 s'ouvre. Dans cet exemple de réalisation, la tension VPR qui reste sur la sortie S est alors évacuée à la masse dans le cas où dans le cycle suivant l'entrée A est à « 0 ». L'entrée Ab est alors dans l'état « 1 » ce qui connecte la sortie S à la masse, du fait de la fermeture de l'interrupteur T7 qui est dans un état inverse de celui de T1. Cet exemple de réalisation permet d'éviter que les noeuds de sortie restent à une tension flottante pendant un temps trop élevé, si par exemple le ou les états suivants pris par l'entrée A étaient 0, ce qui évite de rendre le circuit logique perturbable par des charges électrostatiques.

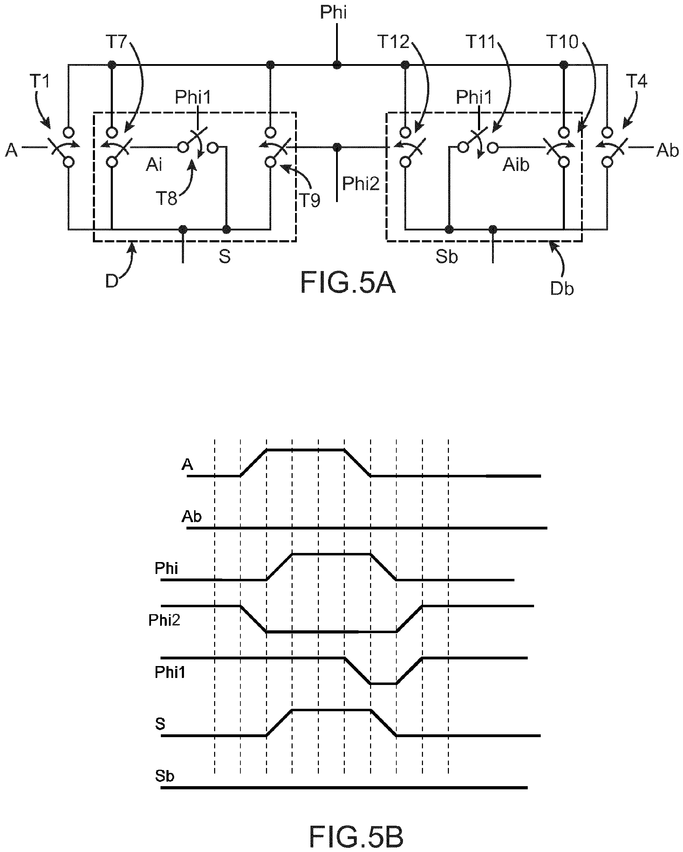

Sur la figure 5A est représenté un deuxième mode de réalisation d'un circuit logique selon l'invention. Sur la figure 5B, sont représentés les chronogrammes des signaux aux entrées, sorties et aux entrées de synchronisation de commande.

Dans ce mode de réalisation, la fonction logique comporte un interrupteur mécanique T1 commandé par le signal d'entrée A. Les moyens de décharge D comportent trois interrupteurs T7, T8 et T9. L'interrupteur T8 est commandé par une première entrée de synchronisation Phi1 et l'interrupteur T9 est commandé par une deuxième entrée de synchronisation Phi2. La fonction inverse a une structure symétrique, l'entrée comporte un interrupteur T4 commandé par le signe d'entrée Ab, et les moyens Db comporte trois interrupteurs T10, T11 et T12.

L'interrupteur T11 est commandé par la première entrée de synchronisation Phi1 et l'interrupteur T12 est commandé par la deuxième entrée de synchronisation Phi2.

Le fonctionnement de ce circuit logique va maintenant être expliqué à l'aide des chronogrammes de la figure 5B.

Tout d'abord, un signal d'entrée est par exemple appliqué à l'entrée A de sorte à la positionner à « 1 », l'entrée Ab est donc « 0 », i.e. le signal d'entrée A monte de 0 à VDD et dépasse donc VPC. Le signal d'entrée est visible sur la figure 5B et varie adiabatiquement. Toutes les tensions sont initialement à 0V sauf Phi2 et Phi1 qui sont à VDD donc T9, T12, T8 et T11 sont les seuls interrupteurs à être passants. L'interrupteur mécanique T1 est donc fermé et conducteur quand A atteint VPC

La première entrée d'alimentation et de synchronisation Phi applique ensuite une tension d'alimentation qui augmente de 0 à $V_{DD}$. Du fait de la fermeture de T1, la sortie S connaît la même variation de tension comme cela est visible sur la figure 5B. La sortie Sb reste, quant à elle, à 0V.

La tension à la sortie S augmente pour atteindre au moins la valeur VPC, ce qui provoque la fermeture de l'interrupteur mécanique T7, l'interrupteur T8 étant fermé. L'interrupteur T7 devient conducteur.

Le signal d'entrée appliqué à l'entrée A, variant adiabatiquement, la tension appliquée à l'entrée A et donc à l'interrupteur mécanique T1 diminue ensuite et passe en dessous de VPR, T1 s'ouvre et n'est plus conducteur. La sortie S reste cependant connectée à l'horloge Phi par l'interrupteur mécanique T7.

La première entrée de synchronisation Phi1 passe à l'état 0, alors que Phi et la sortie S sont à l'état 1. L'interrupteur T8 devient ouvert, isolant le noeud Ai. La tension au noeud Ai est la tension aux bornes d'une capacité Ci formée par l'entrée de T7 et la courte interconnexion entre T7 ET T8. Dans cette phase cette capacité est isolée électriquement puisque T8 est ouvert. La tension aux bornes conserve donc sa valeur Vdd et T7 reste conducteur.

La tension à l'horloge Phi diminue de manière adiabatique, la tension à la sortie S diminue alors également de manière adiabatique et cela pendant toute la durée de la décharge, T7 étant conducteur. La sortie se décharge donc totalement à 0V. La capacité en Ai en revanche se décharge vers 0V de manière non adiabatique la période suivante quand Phi1 remonte à Vdd puisqu'elle est alors connectée à 0V par T8. Une énergie 1/2.Ci .Vdd² sera donc dissipée.

La deuxième entrée de synchronisation Phi2 passe à 1 en phase inactive, i.e. quand aucun signal n'est envoyé en entrée. L'interrupteur 9 se ferme assurant la connexion entre la première entrée d'alimentation et de synchronisation Phi et la sortie S en phase inactive.

Le mode de réalisation permet d'obtenir une dissipation entièrement adiabatique de l'énergie, hormis la décharge des noeuds internes Ai et Aib.

Notons que dans ce mode de réalisation, on peut envisager de ne pas mettre en oeuvre les interrupteurs T9, T12 et le signal Phi2 car ils servent à éviter que les sorties S et Sb ne restent trop longtemps à un potentiel flottant.

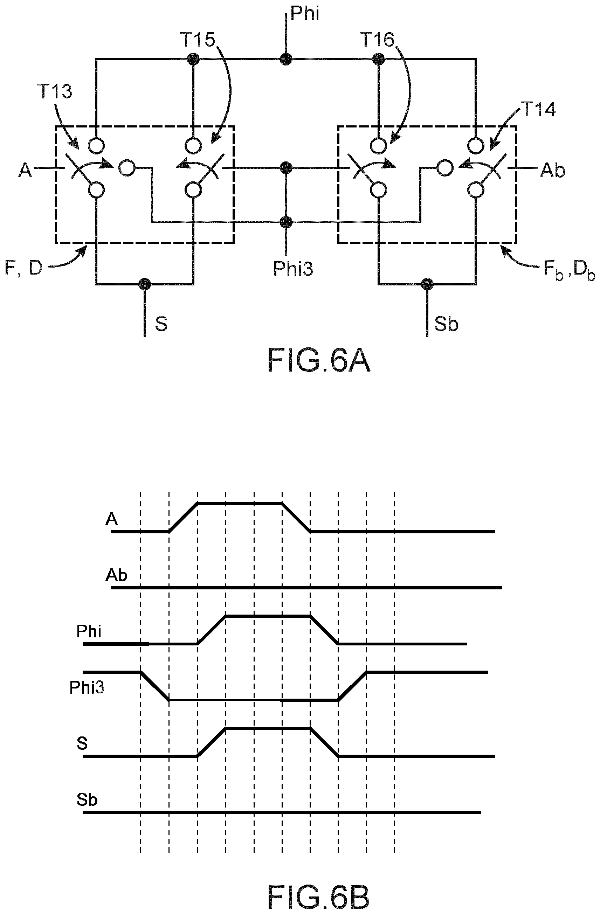

Sur la figure 6A, on peut voir un troisième mode de réalisation particulièrement avantageux permettant également une dissipation entièrement adiabatique de l'énergie à la décharge de la capacité interne près.

Dans ce troisième mode de réalisation, l'interrupteur mécanique T13 réalise la fonction logique F, assure la décharge de la sortie S, et forme donc une partie des moyens de décharge D, et l'interrupteur mécanique T14 de la fonction complémentaire Fb assure également la décharge de la sortie Sb et forme donc une partie des moyens de décharge Db. Pour cela, au moins les interrupteurs T13 et T14 sont des interrupteurs bistables.

On entend par "interrupteur bistable" dans la présente demande, un interrupteur qui se ferme par l'application d'une tension de fermeture et conserve l'état fermé même lorsque que la tension de fermeture n'est plus appliquée, et requiert l'application d'une tension d'ouverture sur une électrode supplémentaire pour être ouvert. Il s'agit d'interrupteurs commandés en fermeture et en ouverture.

Les moyens D sont formés également avantageusement par un interrupteur mécanique T15 et les moyens Db sont formés avantageusement par un interrupteur mécanique T16.

Cet interrupteur comporte en plus des éléments décrits pour l'interrupteur simple une autre électrode de commande permettant de placer l'interrupteur de type bistable dans l'état ouvert par application d'une tension appelée également VPR. Contrairement à l'interrupteur simple, l'interrupteur bistable reste fermé après une commutation même si la tension de commande repasse à 0V. Par exemple, les forces d'adhérence à la condition qu'elles soient supérieures aux forces mécaniques permettent ce fonctionnement

Un exemple d'un interrupteur bistable est par exemple décrit dans le document Owen Y. Loh and Horacio D. Espinosa, Nanoelectromechanical contact switches, Nature Nanotechnology, April 29 2012.

Le circuit logique comporte une entrée de synchronisation Phi3 commandant l'ouverture des interrupteurs 13 et 14, et elle commande également la fermeture des interrupteurs T15 et T16. Dans l'exemple représenté, les interrupteurs T15 et T16 sont commandés uniquement en fermeture, en l'absence de tension, les interrupteurs s'ouvrent.

Le fonctionnement de ce circuit logique va maintenant être décrit à l'aide des chronogrammes de la figure 6B.

Dans l'état initial, Phi3 est à l'état 1; T13 et T14 sont donc ouverts, tandis que T15 et T16 sont fermés reliant S et Sb à Phi qui est à l'état 0.

Tout d'abord, l'horloge Phi3 passe à l'état 0, provoquant l'ouverture des interrupteurs T15 et T16.

Ensuite, un signal d'entrée est par exemple appliqué à l'entrée A de sorte à la positionner à «1 », l'entrée Ab est donc « 0 », i.e. le signal d'entrée A applique une tension au moins égale à VPC. Le signal d'entrée est visible sur la figure 6B et varie adiabatiquement.

L'interrupteur mécanique T13 est donc fermé et conducteur quand A atteint VPC, l'interrupteur complémentaire T14 est ouvert.

La première entrée d'alimentation et de synchronisation Phi applique ensuite une tension d'alimentation qui augmente de 0 à $V_{DD}$. Du fait de l'état conducteur de T13, la sortie S connaît la même variation de tension comme cela est visible sur la figure 5B. La sortie Sb reste, quant à elle, à 0V.

Le signal d'entrée appliqué à l'entrée A, passe ensuite à l'état 0. Mais du fait de la propriété bistable de l'interrupteur T13, celui-ci reste à l'état conducteur. L'interrupteur T13 assure la connexion entre la sortie S et la première entrée d'alimentation et de synchronisation Phi. La tension à la première entrée d'alimentation et de synchronisation Phi diminuant de manière adiabatique, la tension à la sortie S diminue alors également de manière adiabatique. La sortie S reste connectée à la première entrée d'alimentation et de synchronisation Phi jusqu'à décharge complète. Lorsque la sortie S est complètement déchargée, l'entrée de synchronisation Phi3 passe à l'état 1 ouvrant l'interrupteur T13 (T14 est déjà ouvert) et fermant les interrupteurs 15 et 16. L'entrée de synchronisation Phi3 est utilisée pour remettre dans un état bloqué les interrupteurs bistables, une fois la sortie déchargée, et pour assurer une connexion entre les sortie S et Sb et la première entrée d'alimentation et de synchronisation Phi pendant la phase inactive par les interrupteurs T15 et T16.

En variante, il peut être envisagé d'utiliser en lieu et place des interrupteurs T15 et T16 commandés uniquement en fermeture des interrupteurs bistables, ce qui permet de simplifier le procédé de réalisation en réduisant le nombre de composants différents. Une entrée de synchronisation supplémentaire dérivée directement de Phi3 est alors prévue pour commander en ouverture les interrupteurs bistables T15 et T16. L'entrée de synchronisation supplémentaire pourrait être distincte de l'entrée de synchronisation Phi3.

Ce circuit logique permet une dissipation d'énergie totalement adiabatique. En outre, il présente l'avantage de ne mettre en oeuvre que deux entrées de synchronisation par rapport au deuxième mode de réalisation et d'être de réalisation plus simple.

Notons que dans ce mode de réalisation, on peut envisager de ne pas mettre en oeuvre les interrupteurs T15 et T16 car ils servent à éviter que les sorties S et Sb ne restent trop longtemps à un potentiel flottant.

Les circuits logiques selon l'invention peuvent être réalisés par des technologies silicium, mais cela n'est pas limitatif. En fonction du degré de miniaturisation recherché, des technologies mécaniques peuvent être dans certains cas mieux adaptées que les technologies à base de semi-conducteurs pour obtenir des performances de très faible consommation.

Il sera compris que tous les circuits logiques peuvent être réalisés à partir des trois modes de réalisation décrits. Il peut être envisagé de combiner ces trois modes dans un même circuit logique.

Les circuits logiques de l'invention sont particulièrement intéressants pour des applications exigeant une consommation très faible, telles que par exemple les systèmes autonomes portables.

Les systèmes à haut degré de parallélisation, qui demandent des fréquences de fonctionnement par bloc assez faible peuvent également utiliser de tels circuits.

## Revendications

1. Circuit logique adiabatique présentant au moins une première et une deuxième entrées (A, Ab), une première et une deuxième sorties (S, Sb) et au moins une entrée d'alimentation et de synchronisation (Phi), ce circuit comportant :

   - un premier dispositif logique (F) comprenant au moins un premier interrupteur microélectromécanique et/ou nanoélectromécanique, dit premier interrupteur logique, au moins en partie piloté par la première entrée et relié à la première sortie et à l'entrée d'alimentation et de synchronisation (Phi),
   - un deuxième dispositif logique dit complémentaire (Fb) assurant une fonction logique complémentaire du premier dispositif logique comprenant au moins un deuxième interrupteur microélectromécanique et/ou nanoélectromécanique, dit deuxième interrupteur logique, au moins en partie piloté par la deuxième entrée et relié à la deuxième sortie et à l'entrée d'alimentation et de synchronisation (Phi),
   **caractérisé en ce**
   - **qu'**un signal à la première entrée ou à la deuxième entrée de sorte à la positionner à une valeur numérique haute est appliqué, avant celui à l'entrée d'alimentation et de synchronisation de sorte à l'augmenter à une valeur nominale de tension d'alimentation,
   - **que** le circuit logique comporte des premier (D) et deuxième (Db) dispositifs de décharge reliés respectivement entre la première sortie (S) et l'entrée d'alimentation et de synchronisation (Phi) et entre la deuxième sortie (Sb) et l'entrée d'alimentation et de synchronisation (Phi), lesdits premier (D) et deuxième (Db) dispositifs de décharge assurant une décharge au moins partielle des première (S) et deuxième (Sb) sorties, lesdits premier (D) et deuxième (Db) dispositifs de décharge comportant respectivement un ou plusieurs interrupteurs, le ou les interrupteurs étant commandés, lesdits interrupteurs étant des interrupteurs microélectromécanique (T2, T3) et/ou nanoélectromécanique, dit interrupteur décharge.

2. Circuit logique adiabatique selon la revendication 1, dans lequel les interrupteurs des premier (D) et deuxième (Db) dispositifs de décharge sont des interrupteurs à cycle d'hystérésis.

3. Circuit logique adiabatique selon la revendication 1 ou 2, dans lequel la première sortie (S) est reliée à la masse par l'intermédiaire d'un troisième dispositif logique (Fb') complémentaire du premier dispositif logique et piloté par la deuxième entrée (AB) et la deuxième sortie (Sb) est reliée à la masse par l'intermédiaire d'un quatrième dispositif logique (F') complémentaire du deuxième dispositif logique et piloté par la première entrée (A).

4. Circuit logique adiabatique selon la revendication 3, dans lequel le troisième dispositif logique comporte un premier interrupteur microélectromécanique et/ou nanoélectromécanique de connexion à la masse (T5), ledit premier interrupteur de connexion à la masse étant commandé de sorte à être dans un état inverse de celui du premier interrupteur logique (T1), et le quatrième dispositif logique comporte un deuxième interrupteur microélectromécanique et/ou nanoélectromécanique de connexion à la masse (T6), ledit deuxième interrupteur de connexion à la masse étant commandé de sorte à être dans un état inverse de celui du deuxième interrupteur logique (T4).

5. Circuit logique selon l'une quelconque des revendications 1 à 4, dans lequel tout ou partie des interrupteurs logiques ((F, Fb, F', Fb') sont des interrupteurs bistables.

6. Circuit logique selon l'une quelconque des revendications 1 à 5, dans lequel les premier (D) et deuxième (Db) dispositifs de décharge sont commandés respectivement par la première sortie (S) et la deuxième sortie (Sb).

7. Circuit logique selon l'une des revendications 1 à 3, comportant aux moins une première entrée de synchronisation (Phi1) et une deuxième entrée de synchronisation (Phi2), et chacun des premier (D) et deuxième (Db) dispositifs de décharge comportant au moins trois interrupteurs microélectromécaniques et/ou nanoélectromécaniques (T7, T8, T9, T10, T11, T12), dans lequel un (T7) des trois interrupteurs du premier dispositif de décharge est destiné à réaliser la connexion entre la première sortie et l'entrée d'alimentation et de synchronisation, un autre (T8) parmi les trois interrupteurs du premier dispositif de décharge (D) est commandé par la première entrée de synchronisation (Phi1) de sorte à maintenir la connexion entre la première sortie (S) et l'entrée de synchronisation (Phi) jusqu'à décharge complète de la première sortie, en conservant ledit interrupteur de connexion (T7) conducteur, et la deuxième entrée de synchronisation (Phi2) assure la connexion entre la première sortie (S) et l'entrée d'alimentation et de synchronisation en fermant un autre (T9) des trois interrupteurs du premier dispositif de décharge (D) dans une phase inactive du circuit logique, et dans lequel un (T10) des trois interrupteurs du deuxième dispositif de décharge (Db), dit interrupteur de connexion, est destiné à réaliser la connexion entre la deuxième sortie (Sb) et l'entrée d'alimentation et de synchronisation (Phi), un autre (T11) parmi les trois interrupteurs du deuxième dispositif de décharge (Db) est commandé par la première entrée de synchronisation (Phi1) de sorte à maintenir la connexion entre la deuxième sortie (Sb) et l'entrée d'alimentation et de synchronisation (Phi) jusqu'à décharge complète de la deuxième sortie (Sb), en conservant l'interrupteur de connexion (T10) conducteur, et la deuxième entrée de synchronisation (Phi2) assure la connexion entre la deuxième sortie (Sb) et l'entrée d'alimentation et de synchronisation (Phi) en fermant un autre (T12) des trois interrupteurs du deuxième de décharge (Db) logique dans une phase inactive du circuit logique.

8. Circuit logique adiabatique selon la revendication 1 ou 2, dans lequel le premier interrupteur logique (T13) du premier dispositif logique forme une partie du premier dispositif de décharge (D), ledit premier interrupteur logique (T13) étant commandé en fermeture et en ouverture, ledit premier interrupteur logique (T13) étant commandé de sorte à assurer la décharge complète de la première sortie (S), et dans lequel le deuxième interrupteur logique (T14) du deuxième dispositif logique forme une partie du deuxième dispositif de décharge (Db), ledit deuxième interrupteur logique (T14) étant commandé en fermeture et en ouverture, ledit deuxième interrupteur logique (T14) étant commandé de sorte à assurer la décharge complète de la deuxième sortie (Sb).

9. Circuit logique adiabatique selon la revendication 8, comportant une entrée de synchronisation (Phi3) commandant deux interrupteurs supplémentaires (T15, T16) des premier et deuxième dispositifs de décharge de sorte que ladite entrée de synchronisation (Phi3) maintient l'un (T15) ou l'autre (T16) des interrupteurs supplémentaires fermé assurant la connexion entre la première sortie (S) ou la deuxième sortie (Sb) respectivement et l'entrée d'alimentation et de synchronisation, dans une phase inactive du circuit logique.

10. Circuit logique selon l'une des revendication 1 à 9, dans lequel les premier, deuxième interrupteurs logiques, les premier et deuxième interrupteurs de décharge et les premier et deuxième interrupteurs de mise à la masse sont commandés par des forces électrostatiques, des forces magnétiques ou des forces piézoélectriques.

**11.** Circuit intégré comportant au moins un circuit logique selon l'une des revendications 1 à 10.

**12.** Circuit intégré selon la revendication 11, comportant au moins un premier et un deuxième circuits logiques selon la revendication 1 à 10, la première sortie du premier dispositif logique du premier circuit appliquant un signal d'entrée à la première entrée du premier dispositif logique du deuxième circuit et la deuxième sortie du deuxième dispositif logique du premier circuit appliquant un signal d'entrée à la deuxième entrée du deuxième dispositif logique du deuxième circuit.

**Patentansprüche**

**1.** Adiabatische Logikschaltung mit mindestens einem ersten und einem zweiten Eingang (A, Ab), einem ersten und einem zweiten Ausgang (S, Sb) und zumindest einem Versorgungs- und Synchronisationseingang (Phi), wobei die Schaltung umfasst:

- eine erste Logikeinrichtung (F), die zumindest einen ersten mikroelektromechanischen und/oder nanoelektromechanischen Schalter, erster Logikschalter genannt, umfasst, der zumindest teilweise über den ersten Eingang angesteuert wird und mit dem ersten Ausgang und dem Versorgungs- und Synchronisationseingang (Phi) verbunden ist,
- eine komplementäre zweite Logikeinrichtung (Fb), die eine komplementäre Logikfunktion der ersten Logikeinrichtung bereitstellt, die zumindest einen zweiten mikroelektromechanischen und/oder nanoelektromechanischen Schalter umfasst, zweiter Logikschalter genannt, der zumindest teilweise über den zweiten Eingang angesteuert wird und mit dem zweiten Ausgang und dem Versorgungs- und Synchronisationseingang (Phi) verbunden ist,
**dadurch gekennzeichnet, dass**
- ein Signal am ersten Eingang oder am zweiten Eingang zu dessen Positionieren auf einem hohen digitalen Wert vor demjenigen am Versorgungs- und Synchronisationseingang angelegt wird, um diesen auf einen Nennwert der Versorgungsspannung zu erhöhen,
- die Logikschaltung eine erste (D) und eine zweite (Db) Entladungseinrichtung umfasst, die jeweils zwischen dem ersten Ausgang (S) und dem Versorgungs- und Synchronisationseingang (Phi) bzw. zwischen dem zweiten Ausgang (Sb) und dem Versorgungs- und Synchronisationseingang (Phi) verbunden sind, wobei die erste (D) und die zweite (Db) Entladungseinrichtung eine zumindest teilweise Entladung des ersten (S) und des zweiten (Sb) Ausgangs herstellen, wobei die erste (D) und die zweite (Db) Entladungseinrichtung jeweils einen bzw. mehrere Schalter umfassen, wobei der bzw. die Schalter steuerbar sind, wobei die Schalter mikroelektromechanische (T2, T3) und/oder nanoelektromechanische Schalter sind, Entladung Schalter genannt.

**2.** Adiabatische Logikschaltung nach Anspruch 1, wobei die Schalter der ersten (D) und der zweiten (Db) Entladungseinrichtung Schalter mit Hysterezyklus sind.

**3.** Adiabatische Logikschaltung nach Anspruch 1 oder 2, wobei der erste Ausgang (S) über eine dritte Logikeinrichtung (Fb') mit der Masse verbunden ist, die komplementär zur ersten Logikeinrichtung vorgesehen ist und über den zweiten Eingang (AB) angesteuert wird, und der zweite Ausgang (Sb) über eine vierte Logikeinrichtung (F') mit der Masse verbunden ist, die komplementär zur zweiten Logikeinrichtung vorgesehen ist und über den ersten Eingang (A) angesteuert wird.

**4.** Adiabatische Logikschaltung nach Anspruch 3, wobei der die dritte Logikeinrichtung einen ersten mikroelektromechanischen und/oder nanoelektromechanischen Schalter zum Anschließen an die Masse (T5) enthält, wobei der erste Masseanschlussschalter so gesteuert wird, dass er in einem inversen Zustand zu dem des ersten Logikschalters (T1) ist, wobei die vierte Logikeinrichtung einen zweiten mikroelektromechanischen und/oder nanoelektromechanischen Schalter zum Anschließen an die Masse (T6) enthält, wobei der zweite Masseanschlussschalter so gesteuert wird, dass er in einem umgekehrten Zustand zu dem des zweiten Logikschalters (T4) ist.

**5.** Logikschaltung nach einem der Ansprüche 1 bis 4, wobei sämtliche Logikschalter (F, Fb, F', Fb') oder ein Teil davon bistabile Schalter sind.

**6.** Logikschaltung nach einem der Ansprüche 1 bis 5, wobei die erste (D) und die zweite (Db) Entladungseinrichtung jeweils über den ersten Ausgang (S) bzw. den zweiten Ausgang (Sb) gesteuert werden.

**7.** Logikschaltung nach einem der Ansprüche 1 bis 3, enthaltend zumindest einen ersten Synchronisationseingang (Phi1) und einen zweiten Synchronisationseingang (Phi2), wobei jede aus erster (D) und zweiter (Db) Entladungseinrichtung zumindest drei mikroelektromechanische und/oder nanoelektromechanische Schalter (T7, T8, T9, T10, T11, T12) enthält, wobei einer (T7) der drei Schalter der ersten Entladungseinrichtung dazu bestimmt ist, die Verbindung zwischen dem ersten Ausgang und dem Versorgungs- und Synchronisationseingang herzustellen, wobei ein weiterer (T8) der drei Schalter der ersten Entladungseinrichtung (D) über den ersten Synchronisationseingang (Phi1) so gesteuert wird, dass die Verbindung zwischen dem ersten Ausgang (S) und dem Synchronisationseingang (Phi) bis zum vollständigen Entladen des ersten Ausgangs gehalten wird, indem der erste Verbindungsschalter (T7) leitend gehalten wird, und wobei der zweite Synchronisationseingang (Phi2) die Verbindung zwischen dem ersten Ausgang (S) und dem Versorgungs- und Synchronisationseingang herstellt, indem ein weiterer (T9) der drei Schalter der ersten Entladungseinrichtung (D) in einer inaktiven Phase der Logikschaltung geschlossen wird, und wobei einer (T10) der drei Schalter der zweiten Entladungseinrichtung (Db), Verbindungsschalter genannt, dazu bestimmt ist, die Verbindung zwischen dem zweiten Ausgang (Sb) und dem Versorgungs- und Synchronisationseingang (Phi) herzustellen, wobei ein weiterer (T11) der drei Schalter der zweiten Entladungseinrichtung (Db) über den ersten Synchronisationseingang (Phi1) so gesteuert wird, dass die Verbindung zwischen dem zweiten Ausgang (Sb) und dem Versorgungs- und Synchronisationseingang (Phi) bis zum vollständigen Entladen des zweiten Ausgangs (Sb) gehalten wird, indem der Verbindungsschalter (T10) leitend gehalten wird, und wobei der zweite Synchronisationseingang (Phi2) die Verbindung zwischen dem zweiten Ausgang (Sb) und dem Versorgungs- und Synchronisationseingang (Phi) herstellt, indem ein weiterer (T12) der drei Schalter der zweiten logischen Entladungseinrichtung (Db) in einer inaktiven Phase der Logikschaltung geschlossen wird.

**8.** Adiabatische Logikschaltung nach Anspruch 1 oder 2, wobei der erste logische Schalter (T13) der ersten Logikeinrichtung einen Teil der ersten Entladungseinrichtung (D) bildet, wobei der erste logische Schalter (T13) auf- bzw. zugesteuert wird, wobei der erste logische Schalter (T13) so gesteuert wird, dass das vollständige Entladen des ersten Ausgangs (S) hergestellt wird, und wobei der zweite logische Schalter (T14) der zweiten Logikeinrichtung einen Teil der zweiten Entladungseinrichtung (Db) bildet, wobei der zweite logische Schalter (T14) auf- oder zugesteuert wird, wobei der zweite logische Schalter (T14) so gesteuert wird, dass das vollständige Entladen des zweiten Ausgangs (Sb) hergestellt wird.

**9.** Adiabatische Logikschaltung nach Anspruch 8, enthaltend einen Synchronisationseingang (Phi3), der zwei zusätzliche Schalter (T15, T16) der ersten und der zweiten Entladungseinrichtung steuert, so dass der Synchronisationseingang (Phi3) den einen (T15) oder den anderen (T16) der zusätzlichen Schalter geschlossen hält, wodurch die Verbindung zwischen dem ersten Ausgang (S) bzw. dem zweiten Ausgang (Sb) und der Versorgungs- und Synchronisationseingang in einer inaktiven Phase der Logikschaltung hergestellt wird.

**10.** Logikschaltung nach einem der Ansprüche 1 bis 9, wobei der erste und der zweite logische Schalter, der erste und der zweite Entladungsschalter und der erste und der zweite Schalter zum Anlegen an die Masse über elektrostatische Kräfte, magnetische Kräfte oder piezoelektrische Kräfte gesteuert werden.

**11.** Integrierte Schaltung mit zumindest einer Logikschaltung nach einem der Ansprüche 1 bis 10.

**12.** Integrierte Schaltung nach Anspruch 11, enthaltend zumindest eine erste und eine zweite Logikschaltung nach Anspruch 1 bis 10, wobei der erste Ausgang der ersten Logikeinrichtung der ersten Schaltung ein Eingangssignal an den ersten Eingang der ersten Logikeinrichtung der zweiten Schaltung anlegt und der zweite Ausgang der zweiten Logikeinrichtung der ersten Schaltung ein Eingangssignal an den zweiten Eingang der zweiten Logikeinrichtung der zweiten Schaltung anlegt.

**Claims**

**1.** Adiabatic logic circuit having at least one first and one second inputs (A, Ab), one first and one second outputs (S, Sb) and at least one supply and synchronisation input (Phi), with this circuit comprising:

- a first logic device (F) comprising at least one first microelectromechanical and/or nanoelectromechanical switch, referred to as first logic switch, at least partially controlled by the first input and connected to the first output and to the supply and synchronisation input (Phi),
- a second logic device referred to as complementary (Fb) providing a complementary logic function of the first logic device comprising at least one second microelectromechanical and/or nanoelectromechanical switch, referred to as second logic switch, at least partially controlled by the second input and connected to the second output and to the supply and synchronisation input,
**characterized in that**
- a signal is applied to the first input or to the second input such as to position it at a high numerical value, before that the signal at the supply and synchronisation input in order to increase it to a nominal value of the supply voltage,
- the logic circuit comprises first (D) and second (Db) devices for discharging connected respectively between the first output (S) and the supply and synchronisation input (Phi) and between the second output (Sb) and the supply and synchronisation input (Phi), said first (D) and second (Db) devices for discharging providing a discharge at least partially of the first (S) and second (Sb) outputs, said first (D) and second (Db) devices for discharging comprising respectively one or several switch(es), the switch(es) being controlled, said switch(es) being microelectromechanical and/or nanoelectromechanical switch(es) (T2, T3), referred to as discharging switch.

2. Adiabatic logic circuit according to claim 1, wherein the switches of the first (D) and second (Db) devices for discharging are hysteresis cycle switches.

3. Adiabatic logic circuit according to claim 1 or 2, wherein the first output (S) is connected to the ground by the intermediary of a third complementary logic device (Fb') of the first logic device and controlled by the second input (AB) and the second output (Sb) is connected to the ground by the intermediary of a fourth complementary logic device (F') of the second logic device and controlled by the first input (A).

4. Adiabatic logic circuit according to claim 3, wherein the third logic device comprises a first microelectromechanical and/or nanoelectromechanical connection switch to the ground (T5), said first connection switch to the ground being controlled in such a way as to be in a state opposite that of the first logic switch (T1), and the fourth logic device comprises a second microelectromechanical and/or nanoelectromechanical connection switch to the ground (T6), said second connection switch to the ground being controlled in such a way as to be in a state opposite that of the second logic switch (T4).

5. Logic circuit according to any of claims 1 to 4, wherein all or a portion of the logic switches ((F, Fb, F', Fb') are bistable switches.

6. Logic circuit according to any of claims 1 to 5, wherein the first (D) and second (Db) devices for discharging are controlled respectively by the first output (S) and the second output (Sb).

7. Logic circuit according to one of claims 1 to 3, comprising at least one first synchronisation input (Phi1) and one second synchronisation input (Phi2), and with each of the first (D) and second (Db) devices for discharging comprising at least three microelectromechanical and/or nanoelectromechanical (T7, T8, T9, T10, T11, T12) switches, wherein one (T7) of the three switches of the first device for discharging is configured to perform the connection between the first output and the supply and synchronisation input, another (T8) from among the three switches of the first device for discharging (D) is controlled by the first synchronisation input (Phi1) in such a way as to maintain the connection between the first output (S) and the synchronisation input (Phi) until the first output is fully discharged, by maintaining said connection switch (T7) as a conductor, and the second synchronisation input (Phi2) provides the connection between the first output (S) and the supply and synchronisation input by closing another (T9) of the three switches of the first device for discharging (D) in an inactive phase of the logic circuit, and wherein one (T10) of the three switches of the second device for discharging (Db), referred to as connection switch, is intended to perform the connection between the second output (Sb) and the supply and synchronisation input (Phi), another (T11) from among the three switches of the second device for discharging (Db) is controlled by the first synchronisation input (Phi1) in such a way as to maintain the connection between the second output (Sb) and the supply and synchronisation input (Phi) until the second output is fully discharged (Sb), by maintaining the connection switch (T10) as a conductor, and the second synchronisation input (Phi2) provides the connection between the second output (Sb) and the supply and synchronisation input (Phi) by closing another (T12) of the three switches of the second logic discharge device (Db) in an inactive phase of the logic circuit.

8. Adiabatic logic circuit according to claim 1 or 2, wherein the first logic switch (T13) of the first logic device forms a portion of the first device for discharging (D), said first logic switch (T13) being controlled in terms of closing and opening, said first logic switch (T13) being controlled in such a way as provide for the full discharge of the first output (S), and wherein the second logic switch (T14) of the second logic device forms a portion of the second device for discharging (Db), said second logic switch (T14) being controlled in terms of closing and opening, said second logic switch (T14) being controlled in such a way as to provide for the full discharge of the second output (Sb).

9. Adiabatic logic circuit according to claim 8, comprising a synchronisation input (Phi3) that controls two additional switches (T15, T16) of the first and second devices for discharging in such a way that said synchronisation input (Phi3) maintains one (T15) or the other (T16) of the additional switches closed providing the connection between the first output (S) or the second output (Sb) respectively and the supply and synchronisation input, in an inactive phase of the logic circuit.

**10.** Logic circuit according to one of claims 1 to 9, wherein the first, second logic switches, the first and second discharge switches and the first and second grounding switches are controlled by electrostatic forces, magnetic forces or piezoelectric forces.

**11.** Logic circuit comprising at least one logic circuit according to one of claims 1 to 10.

**12.** Integrated circuit according to claim 11, comprising at least one first and one second logic circuits according to claim 1 to 10, with the first output of the first logic device of the first circuit applying an input signal to the first input of the first logic device of the second circuit and with the second output of the second logic device of the first circuit applying an input signal to the second input of the second logic device of the second circuit.

FIG.1

FIG.2A

FIG.2B

FIG.3

FIG.4

FIG.5A

FIG.5B

FIG.6A

FIG.6B

FIG.7

FIG.8

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

• EP 2549654 A1

**Littérature non-brevet citée dans la description**

• **W C ATHAS.** Low power Digital systems based on adiabatic switching principles. *IEEE transactions on VLSI systems,* Décembre 1994, vol. 2 (04

• **OWEN Y. LOH ; HORACIO D.** Espinosa, Nanoelectromechanical contact switches. *Nature Nanotechnology,* 29 Avril 2012